# EUROPEAN PATENT SPECIFICATION

(11) **EP 0 923 128 B1**
(45) Date of publication and mention of the grant of the patent: **14.01.2009**
(21) Application number: 98928599.4
(22) Date of filing: 22.06.1998
(51) Int. Cl.: H01L 23/12, H01L 23/498, H01L 21/56

(54) **Method of manufacturing a semiconductor package**
Herstellungsverfahren für eine Halbleiterpackung
Procédé de fabrication d'un boitier de semi-conducteur

(30) Priority: 23.06.1997 JP 16584797
(43) Date of publication of application: 16.06.1999
(73) Proprietor: Citizen Holdings Co., Ltd., Nishitokyo-shi, Tokyo (JP)
(72) Inventor: ISHIDA, Yoshihiro, Citizen Watch Co., Ltd., Tanashi-shi, Tokyo 188-8511 (JP); IINUMA, Yoshio, Citizen Watch Co., Ltd., Tanashi-shi, Tokyo 188-8511 (JP)
(74) Representative: Liebetanz, Michael
(86) International application number: PCT/JP1998/002757
(87) International publication number: WO 1998/059369

(56) References cited:
- EP-A- 0 706 208
- FR-A- 2 725 305
- JP-A- 8 306 743
- JP-A- 9 260 533
- GREATHOUSE S.: "Chip Size Solutions: A Comparison" PROCEEDINGS OF THE SURFACE MOUNT INTERNATIONAL CONFERENCE, SAN JOSE, CA, USA, 29 - 31 August 1995, pages 36-42, XP008030759
- PATENT ABSTRACTS OF JAPAN vol. 1999, no. 07, 31 March 1999 (1999-03-31) & JP 04 233749 A (MOTOROLA INC), 21 August 1992 (1992-08-21)
- PATENT ABSTRACTS OF JAPAN vol. 014, no. 067 (E-0885), 7 February 1990 (1990-02-07) & JP 01 286430 A (MATSUSHITA ELECTRIC IND CO LTD), 17 November 1989 (1989-11-17)

## Description

### FIELD OF TECHNOLOGY

The present invention relates to a process for fabricating a small semiconductor package comprising an IC chip mounted with a circuit board by means of flip-chip bonding.

### DESCRIPTION OF THE BACKGROUND ART

In line with the trends of semiconductor packages becoming more and more miniaturized and highly integrated, the flip-chip bonding technique has been developed for directly mounting a bare chip on a circuit board by face down bonding. More recently, various types of portable appliances have successively been introduced to the market, including items such as an integrated video camera-video tape recorder and a mobile phone installed with a so-called CSP ("chip-size/scale package"), i.e. a small-sized package having almost the same dimensions as a bare chip. The above circumstances have created a full-fledged requirement for the CSP, whose research and development have seen a rapid progress in recent years.

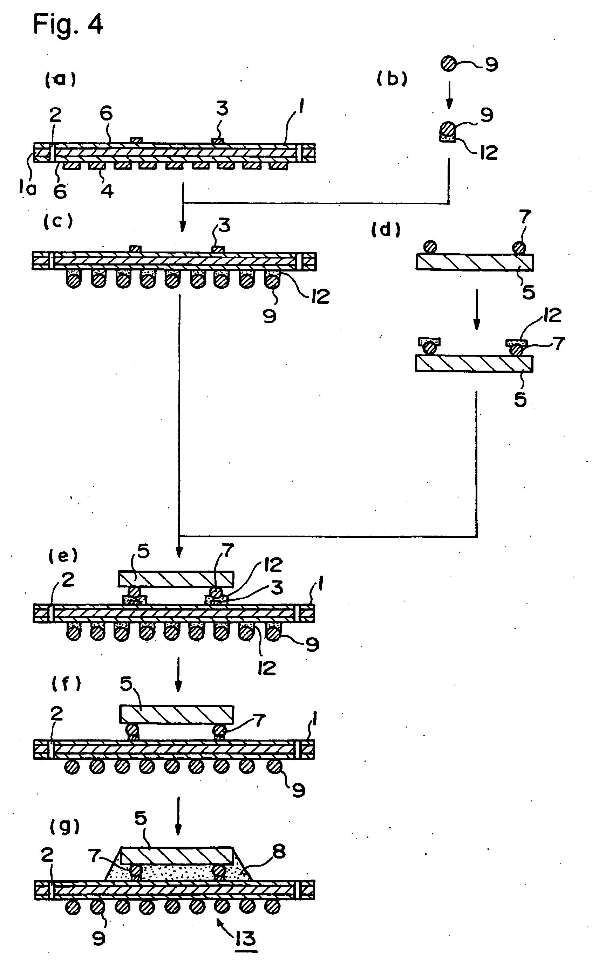

FR-A-2,725,305 discloses a semiconductor device comprising an IC chip and circuit board connected to each other by means of flip-chip bonding, wherein the occupying area of the circuit board is smaller than that of the IC chip. A similar semiconductor device is described in the article "Chip Size Solutions: A Comparison" in Proceedings of the surface mount international conference, San Jose, California, USA, 29-31 August 1995, pages 36 to 42. Both prior art documents do not disclose a method of fabrication of chip scale packages going beyond a method as described in connection of the present Figure 4.

Referring now to Figure 4, an outline of a typical method for preparing a BGA ("ball grid array") for flip-chip bonding is given as an example of a conventional fabrication method for a CSP semiconductor package. In the prior art, descriptions are focused on a unit of a semiconductor package and explanations for a dicing step are omitted.

In this example, first, a through-hole 2 is formed in a circuit board 1 consisting of a resin substrate 1a with copper foils 6 formed on both sides. Next, a copper plating layer (not shown) is formed on both sides of the circuit board 1 by means of electroless copper plating and electrolytic copper plating. Note that the copper plating layer is also formed on the inner wall of the through-hole.

Subsequently, the copper plating layers on both sides of the circuit board 1 are laminated with plating resists (not shown). The plating resists are then exposed and sequentially developed to form a pattern mask (not shown). Thereafter, the copper plating layers are patterned etched by applying an etching solution through this pattern mask. As a result, bonding patterns 3 as an array of electrodes for connecting multiple ICs are formed on the upper surface of the circuit board 1, and at the same time, pad electrodes 4 with a grid-like arrangement are formed on the bottom side of the circuit board 1.

A solder resist treatment is then provided to form a resist film (not shown) on the bottom surface of the circuit board 1. This resist film is made with openings to expose the solderable area of pad electrodes 4. The bottom surface of the circuit board 1 is flat due to formation of this resist film. The circuit board 1 with multiple solderable regions with an identical configuration formed on the bottom surface in grid-like arrangement can be obtained in this manner. (see Figure 4(a)).

Note that in Figure 4(c), as well as Figures 4(d) through 4(g), the illustrations for pad electrodes 4 are omitted.

Next, solder balls 9 are fixed on top of the pad electrodes on the circuit board 1. In the present example, the solder balls 9 are coated with flux 12, as shown in Figure 4(b). Then, the solder balls 9 coated with flux 12 are provisionally fastened on the pad electrodes by means of the flux 12, as shown in Figure 4(c).

As a note, the composition of the solder ball in weight percentage is 60% lead (Pb) and 40% tin (Sn). Hereinafter, the solder with this composition is referred to as a "60-40 solder".

Subsequently, the solder bumps 7 for flip-chip bonding are formed on an IC chip 5. Then, the solder bumps 7 are coated with flux 12, as shown in Figure 4(d).

The IC chip 5 with the solder bumps 7 provisionally attached is mounted on the circuit board 1. At this stage, the solder bumps 7 on the IC chip 5 are positioned on the corresponding bonding pads 3 of the circuit board 1. After the mounting, the IC chip 5 is provisionally fastened on the circuit board 1 with the flux 12 coated on the solder bumps 7, as shown in Figure 4(e)

The circuit board 1 and the IC chip 5 are placed in a furnace and heated to a temperature of 210°C to 230°C to provide a reflow treatment. With the reflow treatment, the flux 12 coated on the solder balls 9 fuses with the solder balls 9 to form solder ball electrodes 10. Also, after the reflow treatment the flux 12 coated on the solder bumps 7 fuses with the solder bumps 7. As a consequence, the IC chip 5 is connected to the circuit board 1 by means of flip-chip bonding through the solder bumps 7 and the bonding pads 3, as shown in Figure 4(f).

In the next resin sealing step, the IC chip 5 mounted on the circuit board 1 is provided with a side mold for protection. The mold exposes the upper surface of the IC chip 5 to ensure adequate heat release, as shown in Figure 4(g).

A flip-chip, cavity-up type BGA 20 can be fabricated in accordance with the above-described procedures.

Meanwhile, with a further requirement to make small-sized portable appliances even more compact, manufacture of semiconductor packages at a lower cost, along with the pressing needs for miniaturizing semiconductor packages, has been demanded in recent years. For that purpose, reducing the size of the circuit board which usually occupies an area larger than the IC chip to a size closer to that of the IC chip is being attempted.

However, equalizing the size of the circuit board to that of the IC chip poses a problem related to lack of handling allowance left for mounting the IC chip on the circuit board.

Moreover, equalizing the size of the circuit board to that of the IC chip leaves almost no gap between the IC chips mounted on the circuit board. As a result, injection of the sealing resin through the gap between the IC chips into the space between the IC chip and the circuit board becomes to be difficult.

Accordingly, in consideration of the above-described problems in the prior art, an object of the present invention is to provide a process for fabricating an inexpensive, small semiconductor package with a superior reliability and high productivity.

### DISCLOSURE OF THE INVENTION

According to the present invention, the process of fabricating a semiconductor package comprising an IC chip and a circuit board connected to each other by means of flip-chip bonding comprises:
a solder bump forming step to prepare solder bumps on each of multiple IC chips formed on a wafer;
a bonding step to connect the circuit boards having a smaller occupying area than that of an individual IC chip to each of the IC chips by means of flip-chip bonding;
a resin sealing step to seal the space between the wafer and the circuit board with a sealing resin; and
a dicing step to cut and separate the wafer into individual IC chips to obtain the completed semiconductor packages.

As described in the above, according to the process of fabricating a semiconductor package in the present invention, circuit boards smaller than the IC chip are connected to individual IC chips formed on a wafer by means of flip-chip bonding. Since the edge portion of the wafer can be used for handling in the flip-chip bonding step, there is no need for preparing a handling allowance at the time of the flip-chip bonding.

Moreover, since the circuit boards are designed to be smaller than the IC chip, gaps can be provided between the circuit boards mounted on each IC chip. As a result, the sealing resin can be easily injected through the gaps between the circuit boards into the space between the IC chip and the circuit boards.

Since the easiness with which the sealing resin can be injected enables to suppress the occurrence of faulty sealing, the reliability of the finished semiconductor package can be improve.

By suppressing the occurrence of faulty sealing, the yield can be improved to economize the manufacturing cost of the semiconductor package, thereby contributing to lower the price.

Furthermore, since the circuit boards are designed to be smaller than the IC chip, the number of the circuit boards available from a unit size of a collective circuit board material can be increased to economize the manufacturing cost of the semiconductor package, thereby contributing to lower the price.

Consequently, in accordance with the process of fabricating a semiconductor package in the present invention, an inexpensive, small semiconductor package with a superior reliability and productivity can be provided.

### BRIEF DESCRIPTION OF THE DRAWINGS

Figure 1 is a cross-sectional view illustrating the configuration of a semiconductor package fabricated in accordance with the process of the present invention.
Figure 2 is a cross-sectional view illustrating the configuration of an essential part of the circuit board constituting the semiconductor package according to Figure 1.
Figures 3(a) to 3(e) describe the process of fabricating a semiconductor package in accordance with the present invention, wherein:
   (a) is an illustration describing the solder bump forming step,
   (b) is an illustration describing the bonding step,
   (c) is an illustration describing the resin sealing step,
   (d) is an illustration describing the dicing step, and
   (e) is an illustration describing the finished semiconductor package.
Figures 4(a) to 4(g), are to describe the process of fabricating a semiconductor package in accordance with the prior art.

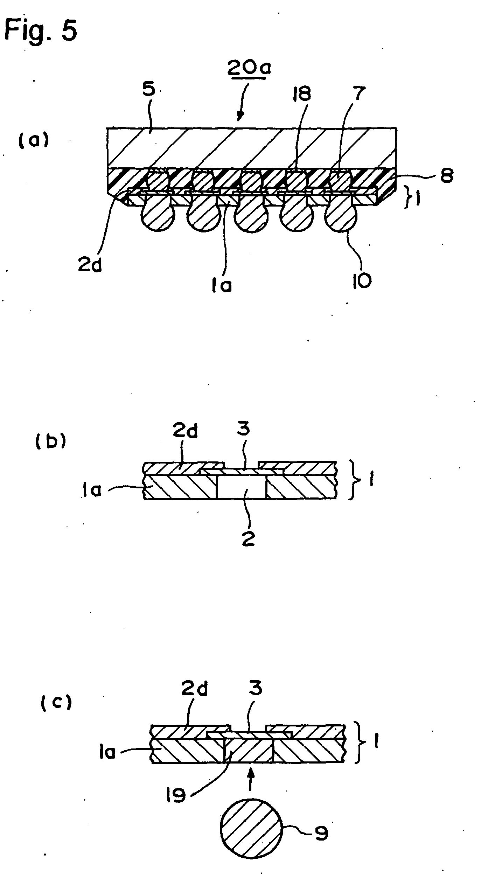

Figure 5(a) is a cross-sectional view illustrating the configuration of a semiconductor package fabricated in accordance with the present invention, and Figures 5(b) and 5(c) are cross-sectional views illustrating the configuration of an essential part of the circuit board constituting the semiconductor package fabricated in accordance with the present invention.

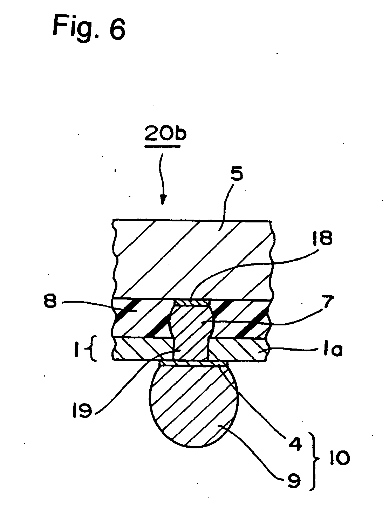

Figure 6 is a cross-sectional view illustrating the configuration of the essential part of the semiconductor package fabricated in accordance with the present invention.

### BEST MODE FOR CARRYING OUT THE INVENTION

In the following sections, more detailed descriptions of preferred embodiments of the present invention will be presented in reference to the drawings.

Note that the drawings herein referred to merely illustrate the dimensions, shapes, and positioning of each component to the extent that the present invention can be understood. Accordingly, the present invention is not to be limited to these illustrative examples.

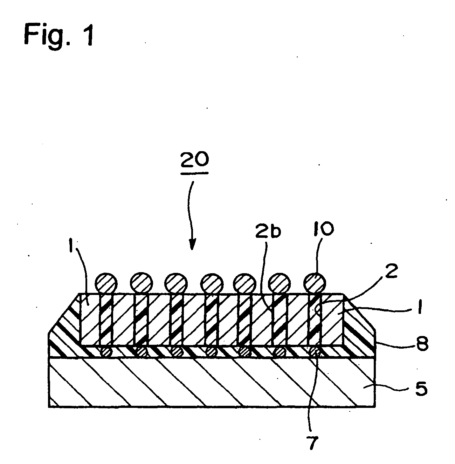

Figure 1 is a cross-sectional view illustrating the configuration of a semiconductor package fabricated in accordance with the process of the present invention.

As shown in Figure 1, the semiconductor package 20 comprises an IC chip 5 and a circuit board 1. The IC chip 5 and the circuit board 1 are connected to each other by means of flip-chip bonding through solder bumps 7. Additionally, the occupying area of the circuit board 1 is set to be smaller than that of the IC chip 5.

Note that the illustration in Figure 1 does not show the internal structures of the IC chip 5.

Since the external dimensions of the circuit board 1 are made to be smaller than the external dimensions of the IC chip 5 as mentioned above, the size of the semiconductor package is determined by the size of the IC chip 5. For this reason, the package 20 allows a further miniaturization of a semiconductor package in comparison with the prior art, wherein an IC chip is mounted on a circuit board larger than the IC chip.

Moreover, in the semiconductor package 20, the space between the IC chip 5 and the circuit board 1 is sealed with a sealing resin 8, along with the lateral surface of the circuit board 1.

In the prior art semiconductor package, on the other hand, the lateral surface of the IC chip which is smaller than the circuit board is covered with a sealing resin.

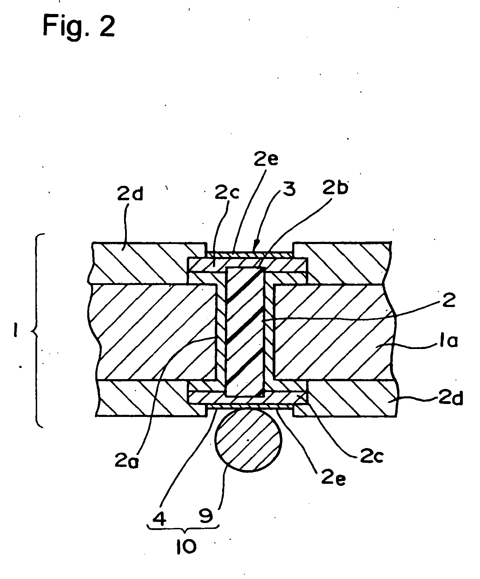

Next, the structure of the circuit board 1 is described referring to Figure 2, which is a cross-sectional view of the essential part of the circuit board 1. The circuit board 1 herein is configured with a glass fabrics-containing resin plate as the base material. Use of a base plate containing glass fabrics enables a wiring pattern on the circuit board 1 to be created with a finer line width, which in turn allows the formation of a wiring pattern with a high density. Use of a base plate containing glass fabrics also improves the operational efficiency.

Alternatively, a ceramic base plate may be used as the base material for the circuit board 1. Use of a ceramic base plate enables formation of a minute wiring pattern with a high density. Moreover, since ceramic materials generally have a low coefficient of linear expansion, distortion of the circuit board 1 resulting from a temperature fluctuation can be suppressed by using a ceramic base plate as the base material.

As shown in Figure 2, the circuit board 1 has on one side a bonding pad 3 provided for flip-chip bonding purposes. The solder bump 7 is bonded tn top of the bonding pad 3. The circuit board 1 is provided with an external connection electrode 10 on the other side. The external connection electrode 10 comprises a pad electrode 4 and a solder ball 9 as a projection electrode formed on top of the pad electrode 4. The semiconductor package of interest is electrically connected, for example, to a mother board (not shown) through the external connection electrode 10. Both the bonding pad 3 and the pad electrode 4 are formed with nickel and gold (Ni/Au) plating layers 2e.

Note that a corresponding illustration of the bonding pad 3 and the pad electrode 4 is omitted in Figure 1.

The circuit board 1 has a through-hole 2 provided for the purpose of electrically connecting the bonding pad 3 and the external connection electrode 10, and on the inner wall surface of the through-hole 2, a copper plating layer 2a is formed. Further, the through-hole 2 is filled with resin 2b. A copper plating layer 2c is provided to cover the two ends at the through-hole filled with the resin 2b. The copper plating layer 2c is electrically connected with the copper plating layer 2a. In addition, the bonding pad 3 and the pad electrode 4 are each formed on the copper plating layer 2c at the respective side. Accordingly, an electrical connection is established between the bonding pad 3 and the projection electrode 10 comprising the pad electrode 4 and the solder ball 9.

Filling the through-hole 2 with the resin 2b as described above makes it possible to prevent the solder from flowing into the through-hole 2. It also permits the formation of the wiring pattern on the surface of the circuit board 1 including the positions where the through-hole 2 is formed, thereby allowing effective utilization of the surface area of the circuit board 1.

In the present package, in particular, the bonding pad 3 and the projection electrode 10 are connected with one-to-one correspondence and, as shown in Figure 1, each projection electrode 10 is positioned at the place where the through-holes 2 are formed. In this arrangement, since the through-holes 2 are filled with the resin 2b, it makes it possible to prevent the projection electrodes 10 from collapsing into the through-holes 2, thereby ensuring precision in the height control of the projection electrode 10.

### (Embodiment)

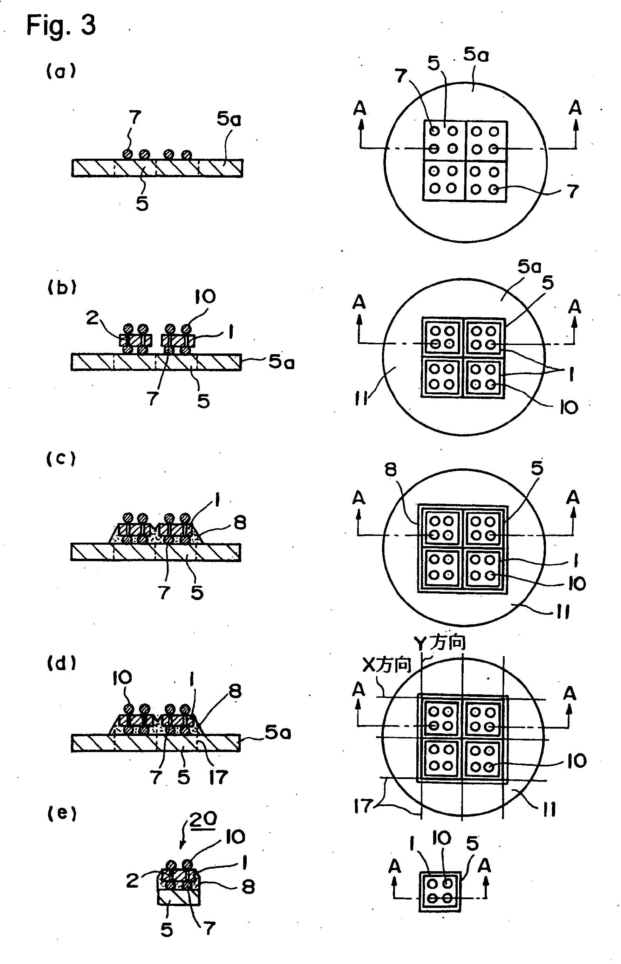

In the following section, an embodiment of the present invention is described referring to Figure 3. It is to be noted that, in Figures 3(a) to 3(e), the right hand side of the drawing shows top views of each fabrication step, whereas on the left hand side of the drawing, cross-sectional views across the A-A plane of each top view are given to the left of corresponding top views. Further, the example given in Figure 3 illustrates the case wherein four pieces of semiconductor package 20 are produced from one wafer, for the sake of convenience in explanation.

In the embodiment, a semiconductor package comprising an IC chip and a circuit board connected to each other by means of flip-chip bonding is fabricated by sequentially going through a solder bump forming step, a bonding step, a resin sealing step, and a dicing step, as described hereafter:

### <Solder bump forming step>

In the first step of solder bump forming, solder bumps 7 are formed on each of a plurality of IC chips 5 formed on a wafer 11, as shown in Figure 3(a). The solder bumps 7 comprise the 60-40 solder material, and are formed on top of the pad electrodes (not shown) prepared on the surface of the IC chip 5.

In forming the solder bumps 7, it is desirable to apply, for example, techniques such as a stud-bump method, a ball-bump method, a plated bump method, and the like. Among the techniques mentioned in the above, the plated bump method permits formation of bumps on an array with tight pad electrode intervals. For this reason, the plated bump method is particularly effective in the miniaturization of IC chips.

### <Bonding step>

In the subsequent bonding step, on each of the IC chip 5 formed on the wafer 11, circuit boards 1 each having a smaller projected area than that of individual IC chips 5 are connected by flip-chip bonding through the soldering bumps 7, as shown in Figure 3(b). In performing the flip-chip bonding, the circuit board 1 is first mounted on the IC chip 5. In doing so, the solder bumps 7 are positioned in such a way that they match with the bonding pads (not shown in the illustration of Figure 3) provided on the circuit board 1 and are coated with flux. Subsequently, by performing a solder reflow treatment, the flux is melted and fused with the solder pads to fasten the circuit board 1 with the IC chip 5.

In the above-mentioned bonding step, the area 5a of the wafer 11 where the IC chips 5 are not formed can be utilized as the handling allowance.

In relation to this step, a description of a typical process for fabricating the circuit board 1 is given in the following. To fabricate the circuit board 1 as shown in Figure 2, a through-hole 2 is first formed by means of NC (numerically controlled) drilling on a base plate 1a of a collective circuit board material. Next, a layer of copper plating 2a is formed on both sides of the base plate 1a by means of electroless copper plating and electrolytic copper deposition. Note that the copper plating layer 2a is formed also on the inner wall surface of the through-hole 2.

Next, the through-hole 2 is filled with resin 2b. Then both two ends of the through-hole 2 filled with the resin 2b are provided with a copper plating layer 2c by means of electroless copper plating and electrolytic copper deposition. The copper plating layer 2c is electronically connected to the copper plating layer 2a.

Subsequently, the above copper plating layers are laminated by using plating resists (not shown). The plating resists are then exposed and developed to form pattern masks (not shown) on either side of the circuit board. Thereafter, a patterned etching step is provided to the copper plating layers by applying an etching solution through the pattern masks. As a result of the patterned etching step above, a bonding pattern 3 as an array of electrodes for connecting multiple ICs is formed on the upper surface of the circuit board 1. At the same time, a pad electrode 4 is formed in a grid-like arrangement on the bottom side of the circuit board 1, in the patterned etching step above.

Following the above, a solder resist treatment is provided to form a resist layer 2d having openings at regions corresponding to the bonding pattern 3 as well as those to the pad electrode 4. These openings are arranged in a grid-like arrangement, accordingly.

Next, a nickel-and-gold (Ni/Au) plating layer 2e is deposited on each of the openings located on the resist layer 2d to form the bonding pattern 3 as well as the pad electrode 4. Subsequently, solder balls 9 are provisionally attached on the pad electrode 4 with flux.

The above solder balls 9 comprise the 60-40 solder material. Accordingly, when the flux melts to fuse with the solder bumps 7 in the solder reflow treatment, the above solder balls 9 are also fastened to the pad electrode 4 to form projection electrodes 10.

### <Resin sealing step>

In the ensuing resin sealing step, the space between the wafer 11 and the circuit board 1 is sealed with a sealing resin, as shown in Figure 3(c). In performing the resin sealing, a thermo-setting type resin is injected through the gap between the circuit boards 1 to seal the space between the circuit board 1 and the IC chip 5 formed on the wafer 11. Furthermore, the resin sealing is also provided to the gaps between juxtaposing circuit boards 1. As a result of this resin sealing step, each circuit board 1 is fastened to the wafer 11.

### <Dicing step>

In the ensuing dicing step, the wafer 11 is cut and separated into individual IC chips 5, as shown in Figure 3 (d). In performing the dicing, the wafer 11 is fastened to a jig (not shown) by such a means as glue or a double-sided adhesive tape. Subsequently, the wafer is cut along the dicing lines (i.e. street lines) 17 lying at right angles to each other in the X and Y directions.

Concurrently with the above dicing, the sealing resin 8 filled between the circuit boards 1 is also cut. As a result of the dicing step, therefore, cut surfaces of the sealing resin are formed.

Subsequently, the wafer 11 with the cuts is divided into individual IC chips 5, which are then separated from the fastening jig by such a means as remover, solvent and the like. Thus the semiconductor package 20 is obtained, as shown in Figure 3(e).

In the following section, another semiconductor package that can be fabricated according to the process of the present invention is described referring to Figures 5(a) to 5(c).

As shown in Figure 5(a), the semiconductor package 20a of the present example comprises an IC chip 5 and a circuit board 1. The IC chip 5 and the circuit board 1 are connected to each other by means of flip-chip bonding through solder bumps 7. As with other embodiments, the occupying area of the circuit board 1 is set to be smaller than that of the IC chip 5 in the semiconductor package 20a of the third embodiment.

The semiconductor package 20a of the above-mentioned configuration is fabricated by mounting the circuit board (i.e. interposer substrate) 1 on the IC chip 5 on which solder bumps 7 are formed.

To accomplish the above, pad electrodes 18 are first formed on the surface of the IC chip 5. The pad electrodes 18 are prepared in an array with 1 mm or less in pitches and in a 5-by-5 grid pattern. Next, solder bumps 7 are formed on each of the pad electrodes 18.

Meanwhile, on a base plate 1a constituting the circuit board 1, through-holes (i.e. device holes) 2 are formed as shown in Figure 5(b). The through-holes 2 are prepared by providing the base plate 1a with a laser drilling or a press punching. In addition, similarly to the pad electrodes 18, these through-holes 2 are prepared in an array with 1 mm or less in pitches and in a 5-by-5 grid pattern.

Subsequently, bonding pads 3 are formed so that the openings of each through-hole 2 on one side of the base plate 1a are covered, as shown in Figure 5(b). When this condition is observed from the other side of the base plate 1a, the bonding pads 3 are exposed at the bottom of the through-holes 2.

Next, a resist layer 2d is formed on the side of the base plate 1a where the bonding pads 3 are prepared. The resist layer 2d is prepared with openings at positions corresponding to the bonding pads 3. Accordingly, when this condition is observed from the above-mentioned side of the base plate 1a, the bonding pads 3 are exposed at the openings of the resist layer 2d.

Subsequently, solder 19 is filled into the through-holes 2 by printing a solder paste on the other side of the base plate 1a and melting it, as shown in Figure 5(c). Thereafter, as shown in Figure 5(c), external connection electrodes 10 are formed by melting and fusing solder balls 9 with the solder 19 that is filled into the through-holes 2. By filling the through-holes 2 with the solder 19 as mentioned in the above, the external connection electrodes 10 can be formed without leaving unnecessary space inside the through-holes 2.

Subsequently, an IC chip 5 is connected by flip-chip bonding to the circuit board 1 that has the external connection electrodes 10 on it. In performing the flip-chip bonding, each of the solder bumps 7 is connected to each of the bonding pads 3 on the circuit board 1. Further, the space between the IC chip 5 and the circuit board 1 is sealed by sealing resin 8. The aforementioned steps thus complete the semiconductor package 20a.

The semiconductor package 20a, in addition, is to be electrically connected, for example, to a mother board (not shown) through the external connection electrodes 10.

It should be noted that, in the present example, the external connection electrodes 10 and the bonding pads 3 are connected via the through-holes 2 prepared on the circuit board 1. Therefore, it is not necessary to prepare a wiring pattern other than the bonding pads 3 on that side of the circuit board 1. The above enables an arrangement of the bonding pads 3 with a shorter pitch than is allowed for a circuit board provided with a wiring pattern and, as a result, permits a further miniaturization of the semiconductor package.

Furthermore, there is no need also to prepare a wiring pattern other than the external connection electrodes 10 on the other surface of the circuit board 1. The above enables an arrangement of the external connection electrodes 10 with a shorter pitch than is allowed for a circuit board provided with a wiring pattern. For example, it is possible to increase the number of external connection electrodes 10 while maintaining their pitches set at 1 mm or less. In this respect, increasing the number of external connection electrodes in a circuit board having a wiring pattern also increases the area occupied by the wiring pattern, making it difficult to set the pitches for the external connection electrodes to 1 mm or less.

In the following section, another semiconductor package that can be fabricated according to the process of the present invention is described referring to Figure 6, which is a cross-sectional view of an essential part of a semiconductor package 20b according to another example of the present invention. Note that the constituent parts identical to those in the previous example are denoted with the same symbols and shown without the detailed explanation.

As shown in Figure 6, in the semiconductor package 20b of the present example, instead of providing a bonding pad on the surface of one side (i.e. the side on which an IC chip 5 is to be flip-chip bonded) of the base plate 1a of the circuit board 1, a pad electrode 4 is provided on the other side of the base plate 1a. The bonding pad 4 is formed so that the opening of the through-hole 2 on the other side of the base plate 1a is covered. Additionally, a solder ball 9 is connected on top of the pad electrode 4 to thereby form an external connection electrode 10 together.

Further, solder 19 is filled into the through-holes 2 from one side of the base plate 1a. When the circuit board 1 is mounted onto the IC chip 5 through flip-chip bonding, the solder 19 and the solder bump 7 of the IC chip 5 are fused together.

Meanwhile, apart from the solder 19 exposed on the through-hole 2 on the side of the one-sided circuit board 1, there is no wiring pattern formed. Accordingly, there is no need to form a resist layer on that side of the base plate 1a. Nor is the resist layer required on the other side of the base plate 1a.

### INDUSTRIAL APPLICABILITY

As described in the foregoing, the process for fabricating a semiconductor package of the present invention is useful in providing a semiconductor package having a superior reliability and productivity, to be installed in various types of small portable appliances such as an integrated video camera-video tape recorder.

## Claims

1. A process for fabricating a semiconductor package comprising an IC chip (5) and a circuit board (1) connected to each other by means of flip-chip bonding, the process comprising:
a solder bump forming step wherein solder bumps (7) are formed on each of a plurality of IC chips (5) formed on a wafer (11) ;
a bonding step wherein circuit boards (1) each having a smaller occupying area than that of individual IC chip (5) are connected to each of said IC chip (5) by flip-chip bonding through said soldering bumps (7);
a resin sealing step wherein the space between the wafer (11) and said circuit board (1) is sealed with a sealing resin (8); and
a dicing step wherein said wafer (11) is cut and separated into individual IC chips (5) to fabricate said semiconductor package(20).

2. The process for fabricating a semiconductor package according to claim 1, wherein resin sealing is provided to the gaps between juxtaposing circuit boards (1) during said resin sealing step.

3. The process for fabricating a semiconductor package according to claim 1 or 2, wherein cut surfaces of said sealing resin (8) are formed when said wafer (11) is diced during said dicing step.

## Patentansprüche

1. Herstellungsverfahren für eine Halbleiterpackung, umfassend einen Integrierter Schaltkreis-Chip (5) und eine Platine (1), verbunden mit dem jeweils anderen durch ein Flip-Chip-Bonding, wobei das Verfahren umfasst:
- einen Lötpunkte ausbildenden Schritt, wobei Lötpunkte (7) auf jedem einer Vielzahl von Integrierter Schaltkreis-Chips (5) ausgebildet werden, die auf einem Wafer (11) ausgebildet sind;
- einen Bonding-Schritt, wobei die Platinen (1), die jeweils einen kleineren Belegungsbereich haben als derjenige eines einzelnen Integrierter Schaltkreis-Chips (5), mit jedem der besagten Integrierter Schaltkreis-Chips (5) durch Flip-Chip-Bonding durch die besagten Lötpunkte (7) verbunden sind;
- einen Harzabdichtungsschritt, wobei der Raum zwischen dem Wafer (11) und der besagten Platine (1) mit einem Abdichtungsharz (8) abgedichtet wird; und
- einen Schneideschritt, wobei der besagte Wafer (11) in einzelne Integrierter Schaltkreis-Chips (5) geschnitten und getrennt wird, um die besagte Halbleiterpackung (20) herzustellen.

2. Verfahren zur Herstellung einer Halbleiterpackung gemäss Anspruch 1, wobei Harzabdichten für die Lücken zwischen benachbarten Platinen (1) während des besagten Harzabdichtungsschritts vorgesehen ist.

3. Verfahren zur Herstellung einer Halbleiterpackung gemäss Anspruch 1 oder Anspruch 2, wobei die Schnittoberflächen des besagten Abdichtungsharzes (8) ausgebildet werden, wenn der besagte Wafer (11) während des besagten Schneideschrittes zerschnitten wird.

## Revendications

1. Procédé de fabrication d'un boîtier de semi-conducteur, comprenant une puce de circuit intégré (5) et une platine (1), connecté l'un avec l'autre par le moyen d'un collage flip-chip, où le procédé comprend:
- une étape de formation de point soudé, où les points soudés (7) sont formés sur chacune d'une pluralité de puces de circuit intégré (5), formés sur un wafer (11),
- une étape de collage, où les platines (1), qui possèdent chacune une zone d'occupation plus petite que celle d'une puce de circuit intégré (5) individuelle, sont connectées avec chacune desdites puces de circuit intégré (5) par collage flip-chip à travers desdits points soudés (7);
- une étape de colmatage par résine, où l'espace entre le wafer (11) et ladite platine (1) est colmaté avec une résine de colmatage (8); et
- une étape de coupure, où ledit wafer (11) est coupé et séparé dans des puces de circuit intégré (5) individuelles pour fabriquer ledit boîtier de semi-conducteur.

2. Procédé pour fabriquer un boîtier de semi-conducteur selon la revendication 1, où le colmatage par résine est prévu pour les espaces entre des platines (1) juxtaposées lors de l'étape de colmatage par résine.

3. Procédé pour fabriquer un boîtier de semi-conducteur selon la revendication 1 ou 2, où les surfaces de coupure de ladite résine de colmatage (8) sont formées quand ledit wafer (11) est coupé lors de ladite étape de coupage.
